# EUROPÄISCHE PATENTSCHRIFT

(11) **EP 0 666 933 B1**
(45) Veröffentlichungstag und Bekanntmachung des Hinweises auf die Patenterteilung: **12.06.1996**
(21) Anmeldenummer: 93918893.4
(22) Anmeldetag: 18.08.1993
(51) Int. Cl.: C23C 14/32, C23C 14/30

(54) **EINRICHTUNG ZUM PLASMAGESTÜTZTEN ELEKTRONENSTRAHL-HOCHRATEBEDAMPFEN**
DEVICE FOR PLASMA-SUPPORTED ELECTRON BEAM HIGH-RATE VAPOUR DEPOSITION
INSTALLATION POUR LA VAPORISATION A GRAND DEBIT PAR FAISCEAU D'ELECTRONS ET PAR ACTION DE PLASMA

(30) Priorität: 19.10.1992 DE 4235199
(43) Veröffentlichungstag der Anmeldung: 16.08.1995
(73) Patentinhaber: FRAUNHOFER-GESELLSCHAFT ZUR FÖRDERUNG DER ANGEWANDTEN FORSCHUNG E.V., D-80636 München (DE)
(72) Erfinder: NEUMANN, Manfred, D-01277 Dresden (DE); SCHILLER, Siegfried, D-01324 Dresden (DE); MORGNER, Henry, D-01257 Dresden (DE)
(86) Internationale Anmeldenummer: DE9300750
(87) Internationale Veröffentlichungsnummer: WO9409176

(56) Entgegenhaltungen:
- US-A- 4 524 717
- US-A- 4 926 791
- US-A- 4 960 073
- US-A- 5 099 790
- Patent Abstracts of Japan, Band 13, Nr 585, C-669, Zusammenfasung von JP-A-1-242773 (Nissin Electric Co. Ltd.) 27 September 1989 and JP-A-1-242773

## Beschreibung

Die Erfindung betrifft eine Einrichtung zur plasmagestützten Elektronenstrahl-Hochratebedampfung, vorzugsweise zum Aufdampfen von Schichten aus Verbindungen auf bandförmige und plattenförmige Substrate. Typische Anwendungsgebiete sind die Bedampfung von Kunststoffolien mit Barriereschichten für die Verpackungsindustrie, mit kratzfesten Schichten für Sonnenschutzfolien oder mit selektiv reflektierenden Schichten für Wärmeschutzfolien. Weitere Anwendungen ergeben sich bei der Beschichtung metallischer Bänder für dekorative Zwecke und für den Korrosionsschutz sowie bei der Beschichtung von Kunststoff- oder Glasplatten zur Erzielung kratzfester oder selektiv reflektierender Oberflächen. Aber auch beim Aufdampfen metallischer Schichten auf unterschiedliche Substrate ergeben sich durch die zusätzliche Plasmaeinwirkung bessere Schichteigenschaften. Insbesondere können eine höhere Packungsdichte der Schicht und damit verbesserte mechanische, optische und elektrische Eigenschaften erzielt werden.

Es ist bekannt, daß durch Plasmaeinwirkung bei der Vakuumbeschichtung verbesserte Schichteigenschaften erreicht werden können. Beispielsweise werden beim Zerstäuben, das naturgemäß unter Plasmaeinwirkung erfolgt, im allgemeinen bessere Schichteigenschaften erzielt als beim Verdampfen. Allerdings sind die Beschichtungsraten beim Zerstäuben relativ gering und für viele Anwendungen unzureichend. Mit Hilfe der Verdampfungstechnik ist es möglich, höhere Raten zu erreichen.

Es ist weiterhin bekannt, ähnliche Schichteigenschaften wie beim Zerstäuben auch durch plasmagestütztes Verdampfen zu erreichen. Dabei werden gleichzeitig mit dem verdampften Material ein Plasma bzw. die aus einem Plasma extrahierten Ionen auf dem Substrat zur Einwirkung gebracht. Die Erzeugung des Plasmas erfolgt entweder durch Ionisierung des Dampf raumes mittels eines separat erzeugten niederenergetischen Elektronenstrahls oder durch Zünden einer selbständigen Entladung zwischen Verdampfer und Substrat [Schiller, S.; Heisig, U.; Panzer, S.: Elektronenstrahltechnologie, VEB Verlag Technik, Berlin, 1976, Seite 187 ff. und Seite 136 ff.] Die höchsten Beschichtungsraten und damit die geringsten Beschichtungskosten sind durch Elektronenstrahl-Hochrateverdampfung erreichbar. Beim Aufdampfen von Metallen werden dabei Beschichtungsraten bis zu 50 µm/s erreicht, aber auch beim Aufdampfen von Verbindungen sind Beschichtungsraten von einigen µm/s erreichbar. Um bei diesen hohen Raten positive Effekte bezüglich der Schichteigenschaften durch zusätzliche Plasmaeinwirkung zu erzielen, sind auch entsprechend hohe Plasmadichten am Substrat erforderlich. Hohe Plasmadichten können z. B. mit an sich bekannten Bogenentladungen erzeugt werden. Es war bisher jedoch nicht möglich, gleichzeitig die hohen Bedampfungsraten und die hohen Plasmadichten am Substrat zur Wirkung zu bringen. Die hohen Plasmadichten führen zu einer derart starken Streuung des zur Verdampfung benötigten Elektronenstrahles, daß die zur Hochratebedampfung erforderlichen Leistungsdichten nicht mehr erreicht werden.
Es ist weiterhin bekannt, eine Plasma-Bogenentladung zusätzlich zum Elektronenstrahl in dem Verdampfertiegel brennen zu lassen [Moll, E.; Buhl, R.; Pulker, H.K.; Bergmann, E.: Activated Reactive Ion Plating Surface and Coatings Technology 39/40(1989), 475-486]. Auch durch diese zusätzliche Verdampferaufheizung werden nicht die Beschichtungsraten der reinen Elektronenstrahl-Hochratebedampfung erreicht. Außerdem ist diese Verfahrensweise nur zum Verdampfen leitfähiger Metalle und nicht zum Verdampfen isolierender Verbindungen geeignet. Darüberhinaus erfolgt die Plasmaeinwirkung vorzugsweise in der Nähe des Verdampfertiegels und nicht in der Nähe des Substrates.

Der Erfindung liegt die Aufgabe zugrunde, eine Einrichtung zum plasmagestützten Elektronenstrahl-Hochratebedampfen zu schaffen, mit welcher es möglich ist, unter Beibehaltung der hohen Bedampfungsraten der Elektronenstrahl-Hochrateverdampfung ein Plasma hoher Dichte in der Nähe des zu beschichtenden Substrats zur Einwirkung zu bringen. Es soll weiterhin eine unzulässige Streuung und Leistungsdichteverringerung des Elektronenstrahls durch das erforderliche hochdichte Plasma vermieden werden.

Erfindungsgemäß wird die Aufgabe nach den Merkmalen des Anspruches 1 gelöst. Weitere vorteilhafte Ausgestaltungen der Einrichtung sind in den Unteransprüchen beschrieben.

Durch den erfindungsgemaßen Aufbau der Einrichtung, d. h. die geometrische Anordnung und Ausbildung der Polschuhe der magnetfelderzeugenden Einrichtung, die räumliche Zuordnung von Substrat, der Hohlkatoden-Bogenquelle und des Magnetfeldes, kann der Abstand zwischen dem Bereich höchster Plasmadichte und der Substratoberfläche so eingestellt werden, daß eine maximale Plasmaeinwirkung auf die Oberfläche des Substrats, aber noch keine thermische Schädigung des Substrats erfolgt. Es hat sich als zweckmäßig herausgestellt, die maximale Feldstärke des schildförmig zwischen dem Bereich hoher Plasmadichte und dem Verdampfer bzw. dem Elektronenstrahl angeordneten Magnetfeldes zwischen 1 und 10 kA/m, vorzugsweise zwischen 2 und 5 kA/m zu wählen. Kleinere Feldstärken können eine ungenügende Separierung, jedoch größere Feldstärken eine unerwünscht starke Ablenkung des Elektronenstrahls zur Folge haben.
Besonders vorteilhaft ist es, für die Erzeugung des Magnetfeldes und die Führung des Elektronenstrahles eine an sich bekannte sog. Magnetfalle zu verwenden. Diese Magnetfalle - ein Magnetsystem mit Polschuhen zu beiden Seiten des Verdampfertiegels - erzeugt über dem Verdampfertiegel ein im allgemeinen horizontales Magnetfeld, durch welches die am Verdampfungsgut rückgestreuten Elektronen von dem zu beschichtenden Substrat ferngehalten werden. Der Elektronenstrahl wird dabei annähernd senkrecht zur Richtung der magnetischen Feldlinien oder schräg gegen die Feldlinien in das horizontale Magnetfeld eingeschossen (DD-P 54 154; DD-P 64 107; DD-P 204 947). Die Kombination der erfindungsgemäßen magnetischen Plasmaabschirmung mit der Magnetfalle zum Abschirmen rückgestreuter Elektronen ist deshalb besonders vorteilhaft, weil im Interesse einer maximalen Plasmadichte an der Substratoberfläche und wegen der damit verbundenen thermischen Substratbelastung eine zusätzliche Belastung durch die am Verdampfer rückgestreuten Elektronen unerwünscht ist.
Zur Erzeugung des Bereiches hoher Plasmadichte in der Nähe der Oberfläche des Substrates sind Hohlkatoden-Bogenquellen besonders vorteilhaft einsetzbar. Damit sind der Elektronenstrahl-Hochratebedampfung angepaßte Ladungsträgerdichten zwischen 10¹¹ und 10¹² cm⁻³ erreichbar. Der Entladungsbogen folgt dem Verlauf der Feldlinien im homogenen Randbereich des Magnetfeldes und trifft auf die auf dem gegenüberliegenden Polschuh angeordnete Anode der Bogenquelle. Durch die Krümmung der Feldlinien im inhomogenen Randbereich des Magnetfeldes erhält der Entladungsbogen eine Auswölbung in Richtung des Substrates. Andererseits wird der Entladungsbogen definiert entlang der gekrümmten Feldlinien geführt, so daß ein unkontrollierbarer Bogenverlauf und damit ein unerwünschtes direktes Auftreffen des Entladungsbogens auf das Substrat oder andere Teile der Bedampfungskammer vermieden werden.
Für die gleichmäßige Beschichtung größerer Substrate ist es zweckmäßig, den Entladungsbogen durch ein magnetisches Wechselfeld am Ort des Bogenaustritts aus der Hohlkatode in einer Ebene parallel zur Substratoberfläche aufzufächern. Die Ablenkfrequenz muß so hoch gewählt werden, daß jeder Punkt der auf dem Substrat aufwachsenden Schicht mehrfach vom Entladungsbogen überstrichen wird. Für sehr breite Substrate ist es vorteilhaft, mehrere Hohlkatoden entlang des einen Polschuhs zur Erzeugung des Magnetfeldes nebeneinander anzuordnen und vor dem gegenüberliegenden Polschuh eine gemeinsame entsprechend langgestreckte Anode anzuordnen. Auch in diesem Fall ist es zweckmäßig, die einzelnen Entladungsbögen der Hohlkatode durch magnetische Wechselfelder fächerförmig parallel zur Substratoberfläche abzulenken, um eine hohe Gleichmäßigkeit der Plasmazone senkrecht zur Bogenrichtung zu erzielen.
Als Anode für die Hohlkatodenentladungen hat sich bei der Abscheidung von Metallschichten eine wassergekühlte Kupferplatte als vorteilhaft erwiesen. Beim Abscheiden isolierender Schichten durch reaktives Verdampfen von Metallen oder durch direktes Verdampfen isolierender Verbindungen ergibt sich nach kurzer Zeit eine Bedeckung der Anode mit einer isolierenden Schicht. In diesem Fall ist es zweckmäßig, das zum Abscheiden isolierender Schichten ohnehin erforderliche Reaktivgas durch Bohrungen in der Anode in die Plasmazone einzulassen. Dadurch erfolgt erstens eine intensive Ionisierung und Anregung dieses Reaktivgases, zweitens wird in der unmittelbaren Umgebung dieser Bohrungen durch den Gasstrom die Kondensation isolierender Schichten reduziert, so daß eine wesentlich längere Betriebsdauer der Bogenentladungen erreicht wird. Der zweite Effekt kann auch durch Einlassen eines Inertgases anstelle eines Reaktivgases erreicht werden. Eine weitere Erhöhung der Betriebsdauer wird erreicht, wenn eine Dampfabschirmung zwischen der plattenförmigen Anode und Verdampfer angeordnet ist und/oder durch Neigen der Anode gegen den Dampfstrahl eine direkte Bedampfung der Anodenoberfläche vermieden wird. Eine weitere Möglichkeit zum Vermeiden isolierender Schichten auf der Anode besteht darin, die Anode so hoch zu heizen, daß sich infolge Rückverdampfung keine isolierenden Schichten abscheiden können. Das Heizen kann im einfachsten Fall dadurch erfolgen, daß die Anode aus einem temperaturbeständigen Material hergestellt und wärmeisoliert gehaltert wird, so daß sie sich durch die aus der Hohlkatodenentladung auftreffenden Elektronen selbst auf die erforderliche Temperatur aufheizt. Dabei ist es vorteilhaft, die Anode aus einzelnen Stäben, vorzugsweise aus W, Ta oder Mo, aufzubauen und an der Rückseite der Anodenstäbe Strahlungsschutzbleche anzuordnen. Infolge der Wärmeleitung längs der Stäbe wird ein breiter Bereich längs der Anode aufgeheizt und freigehalten, wodurch sich eine Verbreiterung der Plasmazone und bei mehreren nebeneinander angeordneten Hohlkatoden eine durchgehend belagfreie Anode ergibt. Durch die Strahlungsschutzbleche wird bei gegebener Bogenleistung eine maximale Aufheizung der Anodenstäbe erreicht. Sollte bei extrem hohen Verdampfungsraten und besonders kritischen Verdampfungsmaterialien trotzdem noch eine Belegung der Anode auftreten, dann ist es zweckmäßig, die Anode zusätzlich durch Stromdurchgang zu heizen. In disem Fall ist es erforderlich, den Stromfluß durch die Anode so zu gestalten, daß das durch den Stromfluß entstehende äußere Magnetfeld nicht zu einer unzulässigen Beeinflussung des Entladungsbogens führt.
Eine vorteilhafte Ausgestaltung besteht darin, den Strom mäanderformig durch parallel zueinander angeordnete Heizstäbe, vorzugsweise aus W, Ta oder Mo, fließen zu lassen und dahinter Strahlungsschutzbleche anzuordnen. Eine andere vorteilhafte Ausgestaltung besteht darin, die Anode aus zwei in Bogenrichtung hintereinander angeordneten Blechen oder Stabgittern aufzubauen, die beide in entgegengesetzter Richtung vom Strom durchflossen werden. Es ist darüberhinaus zweckmäßig, die Kontaktierung der Anode und die Anodenzuleitungen so zu gestalten, daß auch der abfließende Bogenstrom im Bereich des Hohlkatodenbogens kein störendes Magnetfeld erzeugt.

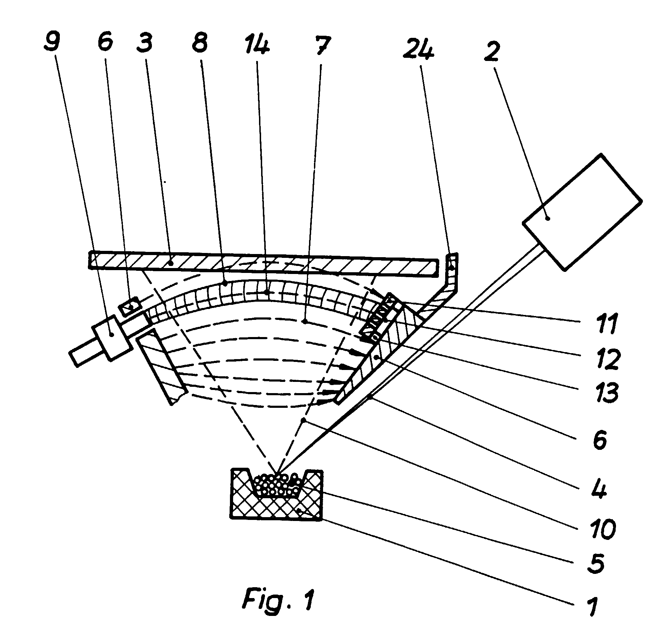

Anhand von zwei Ausführungsbeispielen wird die Erfindung näher erläutert. In den zugehörigen Zeichnungen zeigen:
Fig. 1: einen Schnitt durch eine Bedampfereinrichtung für ebene Substrate mit direktem Einschuß des Elektronenstrahls,
Fig. 2: einen Schnitt durch eine Bedampfereinrichtung mit einer Magnetfalle für bandförmige Substrate.
Die erfindungsgemäße Einrichtung gemäß Fig. 1 besteht aus einem Verdampfer 1, einer schräg darüber angeordneten Elektronenkanone 2 und dem über dem Verdampfer 1 angeordneten zu beschichtenden plattenförmigen Substrat 3, welches senkrecht zur Papierebene über dem Verdampfer 1 bewegt wird. Die Elektronenkanone 2 ist an die Vakuumkammer (nicht gezeichnet) so angeflanscht, daß der Elektronenstrahl 4 schräg auf das in dem Verdampfer 1 befindliche Verdampfungsmaterial 5, in bekannter Weise auf der Oberfläche ablenkbar, auftrifft. Als Verdampfungsmaterial 5 dient Al₂0₃. Oberhalb des Verdampfers 1 sind beiderseits sich gegenüberliegend Polschuhe 6 so angeordnet, daß ein senkrecht zur Zeichnungsebene ausgedehntes Magnetfeld 7 entsteht, dessen Feldlinien vorwiegend parallel zu dem Substrat 3 verlaufen. Die maximale Feldstärke im mittleren und unteren Bereich des Magnetfeldes 7 beträgt 2 kA/m. Im oberen inhomogenen Randbereich des Magnetfeldes 7 wird eine Zone hochdichten Plasmas 8 durch mehrere nebeneinander angeordnete Hohlkatoden 9 erzeugt, die in Öffnungen des linken Polschuhs 6 angeordnet sind. (Es ist nur eine Hohlkatode 9 dargestellt, die anderen sind parallel zu dieser vor und hinter der Zeichnungsebene angeordnet.) An dem rechten Polschuh 6 ist auf der Innenseite eine entsprechend der Anzahl der vorhandenen Hohlkatoden 9 langgestreckte und gegen den Dampfstrahl 10 geneigte wassergekühlte Anode 11 angeordnet. Die Anode 11 besitzt Bohrungen 12, aus denen als Reaktivgas O₂ von der Rückseite der Anode 11 in die Zone des hochdichten Plasmas 8 eingelassen wird. Die Anode 11 ist mittels Isolatoren 13 befestigt und in üblicher Weise mit den Stromversorgungsgeräten für die Hohlkatoden 9 verbunden. Von den Hohlkatoden 9 brennen parallele, zum Substrat 3 hin gewölbte Entladungsbögen 14 zur Anode 11. Diese Entladungsbögen 14 bilden die Zone hochdichten Plasmas 8. Damit trotz der geringen seitlichen Ausdehnung der schlauchförmigen Entladungsbögen 14 eine gleichmäßige Plasmaeinwirkung über das gesamte Substrat 3 erfolgt, wird das Substrat 3 während der Beschichtung senkrecht zu den Entladungsbögen 14 bewegt.

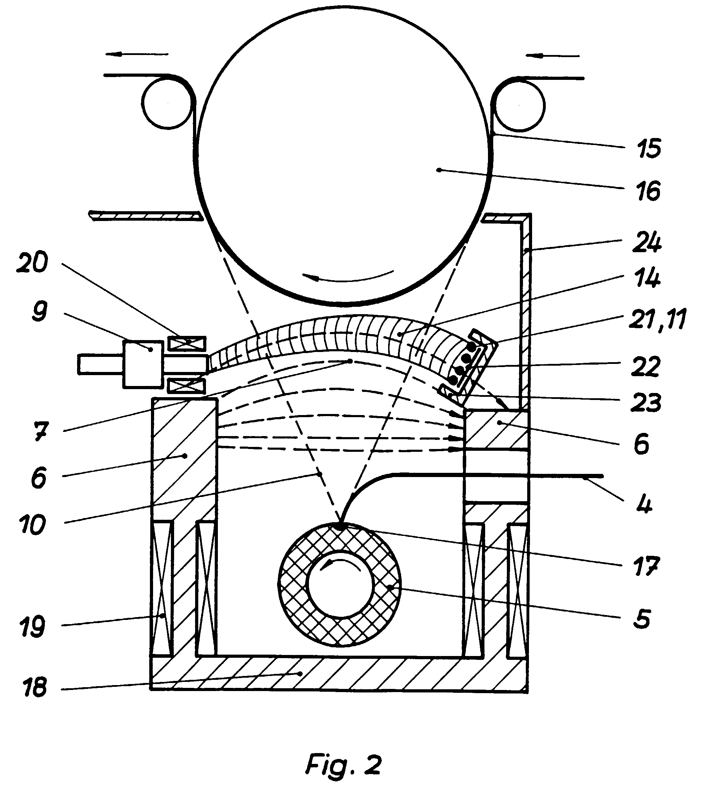

Fig. 2 zeigt eine an sich bekannte Verdampfereinrichtung zum Beschichten von Kunststoffolien 15, die über eine Kühlwalze 16 durch den Verdampfungsraum laufen. Das Verdampfungsmaterial 5 ist ein Rohr aus SiOₓ, welches sich ständig um seine Längsachse dreht, wobei der mit einer Elektronenkanone (nicht gezeichnet) erzeugte Elektronenstrahl 4 waagerecht in den Verdampfungsbereich eingeschossen und so umgelenkt und abgelenkt wird, daß er linienförmig auf dem Rohr parallel zu seiner Längsachse bewegt wird und dadurch eine Verdampfungslinie 17 gebildet wird. Zur Erzeugung des erforderlichen Magnetfeldes 7 ist eine an sich bekannte Magnetfalle 18 so angeordnet, daß zwischen den Polschuhen 6 durch die Magnetspulen 19 ein Magnetfeld 7 entsteht. Das Magnetfeld 7 hat eine max. Feldstärke von 5 kA/m, um die am Verdampfungsmaterial 5 zurückgestreuten Elektronen mit Sicherheit am Erreichen der temperaturempfindlichen Folie 15 zu hindern. Das rohrförmige 5 Verdampfungsmaterial 5 erstreckt sich über die gesamte Breite der zu beschichtenden Folie 15. Die gleichmäßige Bedampfung über die gesamte Folienbreite wird durch programmgesteuerte Ablenkung des Elektronenstrahls 4 längs der Verdampfungslinie 17 auf der Oberfläche des Verdampfungsmaterials 5 gewährleistet. Mindestens die gleiche Ausdehnung senkrecht zur Zeichnungsebene hat das durch die Polschuhe 6 erzeugte Magnetfeld 7. Oberhalb des linken Polschuhs 6 sind über die Folienbreite mehrere Hohlkatoden 9 nebeneinander angeordnet. An jeder Hohlkatode 9 wird durch geeignete Spulen 20 ein magnetisches Wechselfeld erzeugt, das zu 5 einer fächerförmigen Ablenkung des jeweiligen Entladungsbogens 14 parallel zur Folienfläche, d. h. senkrecht zur Zeichnungsebene, führt.
Der Abstand der nebeneinander angeordneten Hohlkatoden 9 zueinander und damit ihre Anzahl pro Folienbreite hängt von den Anforderungen an die Gleichmäßigkeit der Plasmaeinwirkung ab. Die einzelnen senkrecht zur Zeichnungsebene aufgefächerten und sich gegenseitig überlappenden Entladungsbögen 14 brennen zu der am gegenüberliegenden Polschuh 6 angeordneten, sich über die gesamte Folienbreite erstreckenden Anode 11. Die Anode 11 besteht aus mehreren gitterförmig angeordneten und wärmeisoliert befestigten Wolframstäben 21, hinter denen ein wärmestrahlenreflektierendes Strahlungsschutzblech 22 angeordnet ist. Die Wolframstäbe 21 sind durch Isolatoren (nicht gezeichnet) an dem Polschuh 6 befestigt und mit den Stromversorgungsgeräten für die Hohlkatode 9 verbunden. Die Fächerfläche der Anode 11 ist gegen die Richtung des Dampfstrahles 10 geneigt und durch eine Dampfabschirmung 23 gegen direkte Bedampfung geschützt.
In jedem Fall ist durch geeignete Mittel zu verhindern, daß das Plasma nicht unter Umgehung des Magnetfeldes 7 auf den Elektronenstrahl 4 Einfluß nimmt. Dazu dienen Blenden 24, die so angeordnet sind, daß Elektronen oder Ionen aus den Entladungsbogen 14 nicht auf anderem Wege in den Bereich des Elektronenstrahles 4 gelangen können.

## Patentansprüche

1. Einrichtung zum plasmagestützten Elektronenstrahl-Hochratebedampfen, bestehend aus einem Verdampfer mit der zugehörigen Elektronenkanone und einer Plasmaquelle zur Erzeugung eines hochdichten Plasmas, **dadurch gekennzeichnet,** daß die Plasmaquelle in unmittelbarer Nähe des zu beschichtenden Substrats (3; 15) angeordnet ist, daß eine magnetfelderzeugende Einrichtung mit ihren Polschuhen (6) zwischen dem Verdampfer (1) und dem Substrat (3; 15) derart angeordnet ist, daß der Bereich hoher Plasmadichte von dem Verdampfungsmaterial (5) und dem darauf einwirkenden Elektronenstrahl (4) durch das vorwiegend parallel zum Substrat (3; 15) ausgerichtete Magnetfeld (7) der magnetfelderzeugenden Einrichtung getrennt ist und entlang der Randfeldlinien dieses Magnetfeldes (7) in einem zum Substrat (3; 15) hin gewölbten Bogen geführt sind.

2. Einrichtung nach Anspruch 1, **dadurch gekennzeicbnet,** daß die magnetfelderzeugende Einrichtung so ausgebildet und angeordnet ist, daß das Feldstärkemaximum des Magnetfeldes (7) zwischen dem Bereich hoher Plasmadichte und dem Verdampfer (1) bzw. dem Elektronenstrahl (4) 1 bis 10 kA/m, vorzugsweise 2 bis 5 kA/m beträgt.

3. Einrichtung nach Anspruch 1 und 2, **dadurch gekennzeichnet,** daß die magnetfelderzeugende Einrichtung eine für die Abschirmung rückgestreuter Elektronen bekannte Magnetfalle ist.

4. Einrichtung nach mindestens einem der Ansprüche 1 bis 3, **dadurch gekennzeichnet,** daß als Plasmaquelle je nach der Breite des zu beschichtenden Substrats (3; 15) mindestens eine Hohlkatode (9) zwischen einem Polschuh (6) der magnetfelderzeugenden Einrichtung und dem Substrat (3; 15) angeordnet ist und daß an dem gegenüberliegenden Polschuh (6) innenseitig eine entsprechend der Anzahl der Hohlkatoden (9) langgestreckte Anode (11) angeordnet ist.

5. Einrichtung nach Anspruch 1 bis 4, **dadurch gekennzeichnet,** daß die Hohlkatoden (9) in Öffnungen des Polschuhes (6) angeordnet sind.

6. Einrichtung nach Anspruch 4 und 5, **dadurch gekennzeichnet,** daß am Ort des Bogenaustritts aus den Hohlkatoden (9) Spulen (20) für die Erzeugung eines magnetischen Wechselfeldes zur fächerförmigen Ablenkung des jeweiligen Bogens parallel zur Oberfläche des Substrats (3; 15) angeordnet sind.

7. Einrichtung nach Anspruch 1 bis 6, **dadurch gekennzeichnet,** daß die zu den Hohlkatoden 9 gehörende Anode (11) geneigt angeordnet ist und/oder an ihrer Unterseite eine Dampfabschirmung (23) angebracht ist.

8. Einrichtung nach Anspruch 7, **dadurch gekennzeichnet,** daß die Anode (11) eine wassergekühlte Metallplatte, vorzugsweise aus Kupfer ist.

9. Einrichtung nach Anspruch 7 und 8, **dadurch gekennzeichnet,** daß in der plattenförmigen Anode (11) Bohrungen (12) für den Einlaß von Reaktivgas oder eines Inertgases eingebracht sind.

10. Einrichtung nach Anspruch 1 bis 6, **dadurch gekennzeichnet,** daß die Anode (11) aus temperaturbeständigem Material besteht, wärmeisolierend an dem Polschuh (6) befestigt ist und daß an der Rückseite der Anode (11) Strahlungsschutzbleche (22) angeordnet sind.

11. Einrichtung nach Anspruch 7, **dadurch gekennzeichnet,** daß die Anode (11) aus temperaturbeständigen Stäben, vorzugsweise aus Wolfram, Tantal oder Molybdän besteht.

12. Einrichtung nach Anspruch 7 bis 11, **dadurch gekennzeichnet,** daß die Anode (11) durch Stromdurchgang zusätzlich geheizt ist, daß die Stromzuführungen für die Heizung innerhalb und außerhalb der Anode (11) derart ausgeführt sind, daß sich die durch den Stromfluß erzeugten äußeren Magnetfelder im Bereich des Entladungsbogens (14) im wesentlichen kompensieren.

## Revendications

1. Installation pour la vaporisation à grand débit par faisceau d'électrons et par action de plasma, constituée d'un vaporisateur à canon électronique affecté et une source de plasma à engendre un plasma à densité élevée, **caractérisée en ce** que ladite source de plasma est disposée au voisinage direct du substrat à revêtir (3; 15), qu'un dispositif à établir un champ magnétique, ensemble avec ses pièces polaires (6), est disposé entre ledit vaporisateur (1) et ledit substrat (3; 15), de façon que la zone de plasma à densité élevée soit séparée de la matière à vaporiser et du rayon électronique (4) qui en agit, moyennant ledit champ magnétique (7), établi par le dispositif à établir un champ magnétique, qui s'étend surtout en parallèle audit substrat (3; 15, et est guidé le long des lignes de champ marginales de ce champ magnétique (7) selon un arc cintré vers ledit substrat (3; 15).

2. Installation selon la revendication 1, **caractérisée en ce** que ledit dispositif à établir un champ magnétique est configuré et disposé de façon que le maximum de l'intensité du champ magnétique (7) se montent à 1 à 10 kA/m, de préférence à 2 à 5 kA/m, entre la zone à haute densité du plasma et ledit vaporisateur (1), ou respectivement ledit rayon électronique (4).

3. Installation selon les revendications 1 et 2, **caractérisée en ce** que ledit dispositif à établir un champ magnétique est un piège magnétique connu pour le blindage des électrons rétrodiffusés.

4. Installation selon au moins une quelconque des revendications 1 à 3, **caractérisée en ce** que, selon la largeur dudit substrat (3; 15) à revêtir, au moins une cathode évidée (9) est disposée comme source de plasma entre une pièce polaire (6) dudit dispositif à établir un champ magnétique et ledit substrat (3; 15), et en ce qu'à la face intérieur de la pièce polaire opposée (6) une anode (11) est montée, qui est allongée en correspondance avec le nombre desdites cathodes évidées (9).

5. Installation selon les revendications 1 à 4, **caractérisée en ce** que lesdites cathodes évidées (9) sont disposées dans des ouvertures de ladite pièce polaire (6).

6. Installation selon les revendications 4 et 5, **caractérisée en ce** que des bobines (20) sont disposées au point où l'arc sort desdites cathodes évidées (9), afin d'établir un champ magnétique alternatif pour la déviation en éventail de l'arc respectif en parallèle à la surface dudit substrat (3; 15).

7. Installation selon les revendications 1 à 6, **caractérisée en ce** que ladite anode (11) affectée auxdites cathodes évidées (9) est disposée en biais et/ou des moyens écrans de vapeur (23) sont montés à sa surface inférieure.

8. Installation selon la revendication 7, **caractérisée en ce** que ladite anode (11) est une plaque métallique, refroidie par l'eau, de préférence en cuivre.

9. Installation selon les revendications 7 et 8, **caractérisée en ce** que des alésages (12) sont formés dans ladite anode (11) sous forme de plaque, pour l'admission d'un gaz réactif ou d'un gaz inerte.

10. Installation selon les revendications 1 à 6, **caractérisée en ce** que ladite anode (11) est faite d'une matière résistante à la chaleur, est fixée, à isolation thermique, à ladite pièce polaire (6), et en ce qu'à la face arrière de ladite anode des tôles de protection contre les rayonnements (22) sont disposées.

11. Installation selon la revendication 7, **caractérisée en ce** que ladite anode (11) est formée par des barres à constance thermique, de préférence en tungstène, tantale ou molybdène.

12. Installation selon les revendications 7 à 11, **caractérisée en ce** que ladite anode (11) est chauffée, de facon supplémentaire, et en ce que les conducteurs d'amenée pour le chauffage sont configurés, à l'intérieur et à l'extérieur de ladite anode (11), de façon que les champs magnétique extérieurs, qui sont engendrés par l'écoulement du courant électrique, se compensent essentiellement, l'un l'autre, dans la zone dudit arc de décharge (14).

## Claims

1. Apparatus for plasma-assisted high rate electron beam vapour deposition, comprising a evaporator with the associated electron gun and a plasma source for producing a high density plasma, characterized in that the plasma source is located in the immediate vicinity of the substrate (3,15) to be coated, that a magnetic field-producing device with its pole shoes (6) is positioned between the evaporator (1) and the substrate (3,15) in such a way that the high plasma density zone is separated from the evaporant (5) and the thereon acting electron beam (4) by the magnetic field (7) of the magnetic field-producing device which is mainly oriented parallel to the substrate (3,15) and that the high plasma density zone is guided along the marginal field lines of this magnetic field (7) in an arc curved towards the substrate (3,15).

2. Apparatus according to claim 1, characterized in that the magnetic field-producing device is so constructed and arranged that the field strength maximimum of the magnetic field (7) between the high plasma density zone and the evaporator (1) or the electron beam (4) is 1 to 10 kA/m and preferably 2 to 5 kA/m.

3. Apparatus according to claim 1 and 2, characterized in that the magnetic field-producing device is a magnetic trap known for shielding backscattered electrons.

4. Apparatus according to at least one of the claims 1 to 3, characterized in that, as a function of the width of the substrate (3,15) to be coated, the plasma source is constituted by at least one hollow cathode (9) between a pole shoe (6) of the magnetic field-producing device and the substrate (3,15) and that on the inside of the facing pole shoe (6) an anode (11) extended in accordance with the number of hollow cathodes (9) is located.

5. Apparatus according to claims 1 to 4, characterized in that the hollow cathodes (9) are located in openings of the pole shoes (6).

6. Apparatus according to claim 4 and 5, characterized in that at the location of the arc exit from the hollow cathodes (9) coils (20) are provided for producing an altemating magnetic field for the fan-like deflection of the arc parallel to the surface of the substrate (3,15).

7. Apparatus according to claim 1 to 6, characterized in that the anode (11) belonging to the hollow cathodes (9) is inclined and/or a vapour shield (23) is arranged at its bottom side.

8. Apparatus according to claim 7, characterized in that the anode (11) is a water-cooled metal plate, preferably made of copper.

9. Apparatus according to claims 7 and 8, characterized in that holes (12) for the introduction of a reactive or inert gas are arranged in the plate-like anode (11).

10. Apparatus according to claims 1 to 6, characterized in that the anode (11) is made of heat resistant material, is fixed in thermally insulating manner to the pole shoes (6) and radiation reflective plates (22) are provided on the back of the anode (11).

11. Apparatus according to claim 7, characterized in that the anode (11) comprises heat resistant rods, preferably made of tungsten, tantalum or molybdenum.

12. Apparatus according to claims 7 to 11, characterized in that the anode (11) is additionally heated by the flow of an electric current, that the current lines for the heating system inside and outside the anode (11) are located in such a way that the extemal magnetic fields produced by the current flow are largely compensated in the vicinity of the discharge arc (14).
